(19) Europäisches Patentamt
European Patent Office
Office européen des brevets

(11) EP 2 199 263 B1

(12) **EUROPEAN PATENT SPECIFICATION**

(45) Date of publication and mention
of the grant of the patent:
**16.04.2014 Bulletin 2014/16**

(51) Int Cl.:
***C03B 37/018*** *(2006.01)*    ***C23C 16/44*** *(2006.01)*
***C23C 16/04*** *(2006.01)*    ***C23C 16/40*** *(2006.01)*
***C23C 16/455*** *(2006.01)*

(21) Application number: **09015589.6**

(22) Date of filing: **17.12.2009**

(54) **Method and device for manufacturing an optical preform**

Verfahren und Vorrichtung zur Herstellung einer optischen Vorform

Procédé et appareil pour fabriquer une préforme optique

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **19.12.2008 NL 1036343**

(43) Date of publication of application:
**23.06.2010 Bulletin 2010/25**

(73) Proprietor: **Draka Comteq B.V.
1083 HJ Amsterdam (NL)**

(72) Inventors:
• **Milicevic, Igor
5707 PW Helmond (NL)**
• **Van Stralen, Mattheus Jacobus Nicolaas
5045 XN Tilburg (NL)**

• **Hartsuiker, Johannes Antoon
5624 KL Eindhoven (NL)**
• **Heuvelmans, Roland
5629 GK Eindhoven (NL)**

(74) Representative: **Algemeen Octrooi- en
Merkenbureau B.V.
P.O. Box 645
5600 AP Eindhoven (NL)**

(56) References cited:
JP-A- 59 121 129    US-A- 4 445 918
US-A- 4 816 050    US-A- 5 188 648
US-A- 5 504 829    US-A1- 2003 084 685
US-A1- 2005 041 943

## Description

The present invention relates to a method for manufacturing a preform for optical fibres by means of an internal vapour deposition process, which method comprises the following steps:

  i) providing a hollow glass substrate tube,
  ii) supplying dopant-containing glass-forming gases to the interior of the hollow glass substrate tube, wherein the supply flow comprises a main gas flow and one or more secondary gas flows, said main gas flow mainly comprising the glass-forming gases and said one or more secondary gas flows mainly comprising dopant(s),
  iii) creating such conditions in the interior of the hollow glass substrate tube that deposition of glass layers on the interior of the hollow glass substrate tube takes place, and possibly
  iv) subjecting the substrate tube thus obtained to a collapsing treatment so as to form a solid preform. The present invention further relates to a device for supplying gases to the interior of a hollow glass substrate tube, which hollow glass substrate tube is suitable for obtaining an optical preform therefrom, which optical preform is suitable for drawing an optical fibre therefrom, in which device a supply flow takes place, which supply flow comprises a main gas flow and one or more secondary gas flows, said main gas flow mainly comprising the glass-forming gases and said one or more secondary gas flows mainly comprising dopant(s). In addition to dopant(s), such secondary gas flows usually comprise carrier gases.

Processes and apparatuses for manufacturing fiber-drawing preforms are known from US 4,445,918, US 4,816,050 and US 2003/0084685. In addition JP 59-121129 relates to a method for manufacturing a glass body for optical fibers in which method fine powder layers of glass are formed on the inner walls of glass pipes.

Using the present invention, preforms for optical fibres are formed by means of an internal chemical vapour deposition (CVD) technique, wherein doped or undoped glass layers are deposited on the inside of a hollow glass substrate tube. To effect such a deposition, reactive gases are supplied on one side of the substrate tube, viz. the supply side, forming a glass layer on the interior of the substrate tube as a result of the special process conditions. An energy source is moved back and forth along a specific part of the length of the substrate tube for forming a glass layer. The energy source, in particular a plasma generator, supplies high-frequency energy, thereby generating a plasma in the interior of the substrate tube, under which plasma conditions the reactive glass-forming gases will react (the plasma CVD technique). It is also possible, however, to supply the energy in the form of heat, in particular by means of burners, on the outer side of the substrate tube or via a furnace, which surrounds the substrate tube. The aforesaid techniques have in common the fact that the energy source is moved back and forth with respect to the substrate tube.

A drawback of the above-described techniques is the fact that defects may develop near the points of reversal in the layers deposited on the interior of the glass substrate tube on account of the reciprocating movement of the energy source. Such defects are called "taper", in which context a distinction is furthermore made between geometric taper and optic taper. The term "geometric taper" is understood to mean the fact that the thickness of the total deposition, viz. of all the glass layers, is not constant along the length of the tube. The term "optic taper" is understood to mean the fact that the optical properties are not constant along the length of the preform and that consequently the optical properties of the optical fibres obtained from such a preform are not constant, either. Optic taper is mainly determined by differences in the refractive index, or refractive index profiles, along the length of the preform. In addition to an adequate control of the geometric taper, it is also desirable with a view to realising an adequate control of the optical properties of the fibres to be formed that the differences in the longitudinal refractive index profile be as small as possible over a maximum length of the preform. It is a known phenomenon in deposition processes that the length of the deposition zones located at either end of the substrate tube, also referred to as "end tapers", may comprise about 15% of the total length of the substrate tube. The presence of such "taper" leads to an axially non-uniform cross-section of the core. More in particular, said taper forms a region in which the optical and/or geometrical properties of the preform are not uniform. Said non-uniformity will result in degradation of the transmission characteristics of the optical fibre. The use of such "taper" regions in the preform for manufacturing optical fibres is minimized, therefore. Since such "taper" regions form a significant part of the length of the preform rod, the total fibre length to be obtained from a preform is somewhat limited.

Taper thus has this drawback that the useful length of the preform is limited, which means that a smaller amount of optical fibre can be obtained from one preform. In addition to that, the properties of an optical fibre may not be constant along the length of the fibre due to the occurrence of taper. Constant optical properties of a fibre are important to a fibre producer, however, because the producer will have to give certain guarantees as regards the product certificate that is provided, according to which each individual part of the optical fibre must in principle at all times comply with the specification that is issued, in particular if the optical properties are verified, for example by the user.

U.S. Pat. No. US 4,741,747 relates to a method for manufacturing optical fibres in which the reduction of so-called end taper is intended to take place by moving the plasma nonlinearly as a function of time in the region of the reversal point and/or by varying the intensity of the plasma along the length of the glass tube.

U.S. Pat. No. US 4,857,091 relates to a method for manufacturing optical fibres, which mentions a number of parameters that influence the axial position of the local deposition zone in relation to the plasma generator, among which periodic variation of the microwave power, periodic variation of the pressure in the substrate tube and periodic variation of the velocity of the resonator being reciprocated over the tube.

European patent application No. 0 038 982 relates to a method for manufacturing optical fibres, in which the plasma generator is moved along the length of the substrate tube, which plasma generator produces a hot zone, such that said hot zone can be regarded as a so-called "tandem hot zone" comprising at least two zones, viz. zone I and zone II.

European patent application No. 0 333 580 relates to a method for manufacturing preforms for optical fibres in which a variable power microwave generator is used, but in which no use is made of a non-isothermal plasma being moved back and forth between two points of reversal along the length of the substrate tube.

From British patent publication GB 2 118 165 there is known a method for manufacturing a preform for an optical fibre in which the velocity of the heat source being moved axially along the length of the substrate tube is in accordance with a specific mathematical equation, said velocity being a function of the position of said heat source along the substrate tube, so that the total deposition thickness of the glass layers is substantially constant along the length of said tube.

From U.S. Pat. No. 5,188,648 granted to the present applicants there is known a method for manufacturing an optical preform in which the movement of the plasma is interrupted each time the plasma reaches the point of reversal near the gas inlet point of the substrate tube, whilst the glass deposition continues, which interruption of the plasma movement lasts at least 0.1 seconds. Said document relates in particular to a reduction of the geometric taper of the core of the optical preform.

The aforementioned European patent application No. 0 333 580 teaches also that the power of the energy source is continuously controlled during the deposition process on the basis of a signal which is a function inter alia of the degree to which deposition of vitreous layers on the interior of the substrate tube takes place.

The prior art discloses methods for manufacturing preforms in which the optimization of the geometric taper has led to the development of optic taper, and vice versa.

U.S. patent application No. US 2005/0041943 relates to a deposition method in which the plasma is moved along the length of a hollow substrate tube and is changed in a first end region adjacent to a point of reversal, both as a function of time in the deposition process and as a function of the position in the first end region, wherein the end point of the first end region coincides with the point of reversal and wherein the starting point is located further away from the point of reversal than the deceleration point, said first end region having a length that is claimed to suffice for reducing taper in the preform.

The object of the present invention is thus to provide a method for manufacturing a preform from which an optical fibre can be drawn, which preform exhibits a small amount of geometric and optic taper and which has constant optical properties not only at both ends but also in the region between the two ends of the preform.

Another object of the present invention is to provide a preform from which an optical fibre can be drawn, which preform has constant optical properties over a maximum length thereof.

The present invention as described in the first paragraph is characterised in that the secondary gas flow (5) is subdivided into N subflows (9, 10, 11, 12), which N subflows(9, 10, 11, 12) are supplied to the interior of the hollow glass substrate tube (14) together with the main gas flow (6), wherein N ≥ 2, wherein the flow rate of one or more secondary gas flows (5) is set in dependence on the position of the plasma zone over the longitudinal axis of the hollow substrate tube, at least during part of step iii).

The present inventors have found that the "taper" present in a solid preform depends inter alia on the deposition rate of the glass layers on the interior of the hollow substrate, with an increase of the deposition rate generally leading to a deterioration of the uniformity of the deposited glass layers. It has been found that one or more of the above objects can be accomplished by subdividing the secondary gas flow into one or more subflows, the flow rate of each subflow being precisely adjustable, and combining said subflows with one another and subsequently with the main gas flow. Thus, the present inventors have in particular proposed a method and a device for controlling the refractive index in longitudinal direction in the preform.

The flow rate of a medium, such as ideal gas, through an orifice is determined on the basis of the following equation:

$$m = \rho VA = const. \ [kg \, / \, s],$$

where:

m = mass flow of an ideal gas [kg/s],
$\rho$ = gas density [kg/m$^3$],
V = gas velocity [m/s],
A = orifice area [m$^2$].

In practice the flow rate of a gas flow through an orifice is approximated on the basis of the following equation:

$$m = c(p_1 - p_2)A_1$$

where:

c = constant, depending on the gas that is used,
$p_1$ = static pressure in front of the orifice [Pa],
$p_2$ = static pressure after the orifice [Pa],
$A_1$ = orifice area [$m^2$].

On the basis of the above equations it is possible to determine the flow rate of the gas as a function of the pressure drop through an orifice having a diameter r, not taking into account the influence of gravitation.

$$m = c\Delta p r^2 \pi.$$

The present inventors have found that if a number of the aforesaid orifices are used in a parallel arrangement and if the interior radius of the orifice is selected so that the maximum flow through each orifice various in a ration of 1:2:4:8: and the like, it is possible to adjust the total flow of the secondary gas flow in discrete steps. It has thus been found that the magnitude of the gas flow of the dopant(s) can be precisely set.

To realise a precisely control of the magnitude of the secondary gas flow, it is preferable if the number of subflows is at least 4, viz. $N \geq 4$.

Thus the maximum flow of each subflow is preferably at least twice as large as the maximum flow of the other subflow(s). In a specific embodiment, which makes use of four subflows (N=4), for example, the maximum flow of the first subflow is set at 1 (arbitrary unit, AU), the maximum flow of the second subflow is set at 2 (AU), the maximum flow of the third subflow is set at 4 (AU), and the maximum flow of the fourth subflow is set at 8 (AU). Thus it is possible to use 16 settings at most between a minimum flow rate (no flow) and a maximum flow rate, in which latter case the controllable valve in each subflow is open. Consequently, a relation exists between the N subflows, viz. the maximum flow of subflow N is twice as large as the maximum flow of subflow (N-1), and the maximum flow of subflow N is twice as small as the maximum flow of subflow (N+1). Thus, the maximum flow of subflow $N_1$ is preferably twice as large as the maximum flow of subflow $N_2$, if N = 2, more in particular, the maximum flow of subflow $N_i$ is preferably twice as large as the maximum flow of subflow ($N_i$-1), and the maximum flow of subflow N is twice as small as the maximum flow of subflow ($N_i$+1), $N \geq 3$.

To realise an optimally precise setting of the flow rate of the subflow, it is desirable if said one or more secondary gas flows take place in a temperature-controlled environment. Thus, any harmful effects regarding temperature expansion and pressure fluctuations are reduced to a minimum.

In a special embodiment of the present method, it is in particular desirable that a controllable valve and an orifice be present in the flow path of each subflow, with the controllable valve blocking or passing the respective subflow and the orifice controlling the magnitude of the respective subflow. It is in particular desirable if the controllable valve can be set in two positions, viz. an open position and a closed position. The amount of dopant(s) to be supplied to the interior of the hollow substrate is controlled by controlling the valves in each individual subflow. Thus it is possible to set the flow in discrete steps between a minimum flow rate for the secondary gas flow, viz no flow (all valves closed) and a maximum flow (all valves are open).

To realise a precise and quick setting of the magnitude of the secondary gas flow, it is desirable if the control frequency used for controlling the controllable valve is at least 20 Hz, whilst preferably a control frequency of at least 50 Hz is used, with the control of the controllable valve(s) in particular taking place by means of an electronic arithmetic unit.

The present inventors have further found that it is desirable when using the present method for manufacturing optical preforms by means of an internal vapour deposition process to set the flow rate of dopants in the main gas flow at a level which is about 10% lower than the flow rate that would be required for attaining the desired refractive index value (by means of such dopants).

In a special embodiment of the present invention, it is preferable to produce an optical preform in a first step, using a PCVD process, wherein the glass-forming gasses containing dopants are supplied to the interior of the hollow glass substrate tube only via the main gas flow. In other words, in a first step a preform according to the prior art is formed, for example as disclosed in the aforementioned U.S. patent application No. US 2005/0041943. After completion of the deposition process, followed by a usual collapse treatment, the longitudinal refractive index profile of the solid preform thus obtained is determined. Said measured refractive index profile is compared with the desired refractive index profile. Thus it is possible to determine the difference between the measured refractive index profile and the desired refractive index profile at any position of the solid preform. Based on said measured longitudinal refractive index profile and the difference therefrom thus determined, a new deposition process is started, in which use is made of a main gas flow and one or more secondary gas flows. The amount of dopant, for example germanium in the form of germanium tetrachloride, in the main gas flow, which contains $SiO_2$ and silicon tetrachloride, for example, may have been adapted for the purpose of thus increasing the refractive index level to a determined level along the entire length of the preform. After all, the flow rate of the main gas flow will be set at a substantially constant value during the deposition process. The amount of extra dopant is supplied via the secondary gas flow on the basis of the measured difference in the longitudinal refractive index profile, with the flow rate of said one or more secondary gas flows being precisely set as a function of the longitudinal position in the hollow substrate tube. The main gas flow thus provides a "basic setting" of the refractive index and said one or more secondary gas flows for the desired "end level", which end level is substantially constant over a maximum length of the preform. Said control thus preferably takes place by comparing a previously determined refractive index profile with a desired refractive index profile, the difference between the two profiles functioning as a basis for setting the flow rate of at least one of the main gas flow and the secondary gas flows for carrying out steps ii)-iii), so that the controlling of the controllable valve(s) takes place as a function of time during step iii).

In the embodiment in which a correction with germanium takes place, it is desirable if the main gas flow contains an amount of germanium such that the resulting refractive index value is equal to or smaller than the desired refractive index value in the desired longitudinal refractive index profile. Then the amount of extra germanium can be determined as a function of the longitudinal position of the reaction zone during the deposition process in the hollow substrate tube, which amount of germanium is supplied via one or more secondary gas flows. Thus, the flow rate of said one or more secondary gas flows, and thus the amount of (refractive index increasing and/or decreasing) dopant to be supplied, can be varied as a function of time during the deposition process. Because the reaction zone reciprocates over the substrate tube during the deposition process, it is thus possible to set the amount of dopants precisely at any desired moment (and also any desired position on the substrate tube, therefore) during the deposition process.

In a special embodiment, in which the longitudinal refractive index value must be corrected by means of a refractive index decreasing dopant, in particular fluorine, it is desirable to add an amount of fluorine to the main gas flow, such that the resulting refractive index value will be equal to or larger than the desired refractive index value in the intended longitudinal refractive index profile. Subsequently, the amount of additional fluorine can be determined as a function of the longitudinal position of the reaction zone during the deposition process in the hollow substrate tube, which amount of fluorine is supplied via one or more secondary gas flows.

Using the present invention, it has been found to be possible to manufacture an optical preform in which the occurrence of deviations in the refractive index, for example taper, is minimized.

Using the present invention it is in principle possible to realise a substantially uniform refractive index profile. Both refractive index increasing and refractive index decreasing dopants, such as $GeCl_4$ and $C_2F_6$, for example, may be used in the secondary gas flows. Such dopants are incorporated in the glass. In a special embodiment it is preferred that in the main glas flow one or more dopants are present. In specific embodiments it is also desirable to use at least two secondary gas flows, the refractive index decreasing dopants being supplied via one secondary gas flow and the refractive index increasing dopants being supplied via the other secondary gas flow. Thus it is possible to realise a very precise metering of dopants for the purpose of minimizing any deviations in the refractive index, for example taper, in the longitudinal direction. Furthermore, it is preferred that for each dopant a separate secondary gas flow is divided into a number of subflows. However, it is sometimes possible to combine different dopants in one single secondary gas flow, yet takes away the possibility of "individual control".

The present inventors found that in a special embodiment only the secondary flow contains dopant(s). Such an embodiment is especially preferred when low concentrations of dopant(s) are required.

The present invention is used in particular in the field of plasma chemical vapour deposition (PCVD), in which an internal deposition process is carried out in a hollow, quartz substrate tube, using a plasma. In such a process, a microwave generator, in particular a resonator, is reciprocated along the length of the substrate tube, between two reversal points. The plasma zone thus "moves" along the length of the substrate tube, and the deposition of the glass-forming precursors takes place in the plasma zone. Using the present invention it is possible to adapt the gas composition in the substrate tube to the resonator position. In other words, it is desirable to vary the dopant concentration within a "resonator stroke" in dependence on the position, in particular at resonator velocities in the 10-40 m/min range. It is thus possible to have a deposition of glass take place at a predetermined position in the interior of the hollow substrate tube, which deposition makes it possible, on account of the special subdivision into main gas flow and one or more secondary gas flows, to realise any desired refractive index value at any desired position in the hollow substrate tube.

The present invention further relates to a device for supplying gases to the interior of a hollow substrate tube (14), in which hollow substrate tube (14) an internal deposition process is carried out using a plasma zone movable along the length of said substrate tube (14), with the supply flow comprising a main gas flow (6) and one or more secondary gas flows (5), said main gas flow (6) mainly comprising the glass-forming gases and said one or more secondary gas flows (5) mainly comprising dopant(s), characterised in that the secondary gas flow (5) comprises a first distribution unit for dividing the secondary gas flow (5) into N subflows (9, 10, 11, 12) and a second distribution unit for combining all N subflows (9, 10, 11, 12), wherein N ≥ 2, in which device a controllable vale and an orifice are present in the flow path of each subflow (9, 10, 11, 12), with the controllable valve blocking or passing the respective subflow (9, 10, 11, 12) and the orifice controlling the magnitude of the respective subflow (9, 10, 11, 12), said valve being controlled via an electronically controlled measuring and control system to realise any desired refractive index value at any desired position in the hollow substrate tube (14).

In a special embodiment it is desirable that a controllable valve and an orifice be present in the flow path of each subflow, with the controllable valve blocking or passing the respective subflow and the orifice controlling the magnitude of the respective subflow, in particular that the first distribution unit and the second distribution unit be disposed in a temperature-controlled environment.

To obtain a uniform longitudinal refractive index profile of the preform, the device preferably further comprises a system for setting the magnitude of said main gas flow and said one or more secondary gas flows.

The present invention further relates to the use in a plasma chemical vapour deposition (PCVD) process of the method of varying the composition of the doped glass-forming gases to be supplied to the interior of a hollow glass substrate tube as a function of the position of the plasma zone during the deposition of glass layers for controlling the refractive index in longitudinal direction of an optical preform.

To realise a reliable setting, it is desirable that the supply line for the secondary gas flow be substantially leakage proof, in which connection the gas line system is preferably subjected to a leakage test before the production of an optical preform is actually started, which is preferably done by filling the system with a gas under a high pressure, then sealing the entire gas system and subsequently registering the decrease in pressure as a function of time.

The present application will be explained in more detail below by means of an example, in which connection it should be noted, however, that the present invention is by no means limited to such a special example.

Example

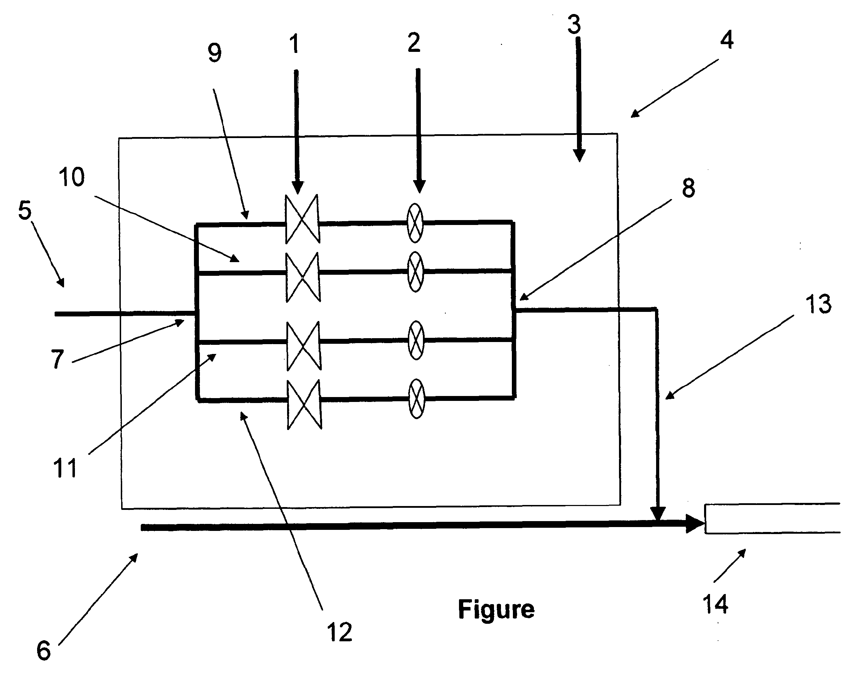

The appended figure shows the gas supply system 4 according to the present invention, which comprises a main gas flow 6 and a secondary gas flow 5, said main gas flow 6 mainly comprising $SiCl_4/O_2$ and said secondary gas flow 5 comprising a germanium-containing compound, for example GeCl4, whilst the secondary gas flow 5 usually comprises a carrier gas, for example, oxygen, in which the dopant is present. Usual dopants, for example refractive index increasing and/or decreasing dopants, such as $GeCl_4$ and $C_2F_6$, for example, are present in the main gas flow 6. The inlet secondary gas flow 5 is subdivided into four subflows 9, 10, 11, 12, using a first distribution unit 7. A controllable valve 1 and an orifice 2 are present in the flow path of each subflow 9-12, the maximum flow value of the subflow 9 being 1 (arbitrary unit), the maximum flow value of the subflow 10 being 2 (AU), the maximum flow value of the subflow 11 being 4 (AU) and the maximum flow value of the subflow 12 being 8 (AU). The subflows 9-12 originating from subdividing inlet secondary gas flow 5 are combined into a secondary gas flow 13 via a second distribution unit 8, which secondary gas outlet flow 13 is combined with the main gas flow 6 and supplied to a hollow glass substrate tube 14. An internal deposition process takes place in the interior of the hollow substrate tube 14, which hollow substrate tube 14 is placed in a furnace (not shown), in which a resonator (not shown) is present, to which microwaves are supplied, which resonator is reciprocated over a specific part of the length of the substrate tube 14 so as to thus create such conditions in the interior of the hollow substrate tube 14 that one or more glass layers will be deposited on the interior of the hollow substrate tube 14. A suitable deposition process is disclosed in the aforementioned U.S. patent application No. US 2005/0041943 in the name of the present applicant. Subsequent to the deposition and collapsing process, the solid preform is provided with additional glass on the outer side, if desired, after which the eventual drawing process for obtaining the optical fibre is carried out.

To realise a correct execution of the aforesaid deposition process, the intended refractive index profile is known in advance, whilst the amount of dopant(s) to be supplied to the interior of the hollow substrate tube 14 is controlled by controlling the valves 1 in each individual subflow 9-12. Thus it is possible in the illustrated embodiment to set at most 16 steps between a minimum flow rate for the secondary gas flow, viz. no flow when all the valves 1 are closed, and a maximum flow rate when all the valves 1 in the subflows 9-12 are open. Such control of the valves 1 takes place via an electronically controlled measuring and control system (software and hardware, not shown). To minimize temperature fluctuations, the gas supply system 4 is connected to a temperature control system 3. Although four subflows 9-12 are shown in the figure, it is also possible to use two, eight, sixteen and the like numbers of subflows 9, 10. In addition to that it is possible to use a second gas supply unit 4 (not shown), in which precise metering of other dopant(s), whether or not in the presence of one or more carrier gases, takes place, which second gas supply unit 4 (not shown) also comprises a number of subflows, each provided with a controllable valve and an orifice, preferably being connected to a temperature control system.

Using the method and device as described in the foregoing for manufacturing an optical preform by means of internal vapour deposition, it has been found to be possible to realise a substantially uniform refractive index profile along part of the length of a hollow substrate tube, in which the deviations from the intended refractive index profile are minimized.

**Claims**

1. A method for manufacturing a preform for optical fibres by means of an internal vapour deposition process, which method comprises the following steps:

i) providing a hollow glass substrate tube (14),
ii) supplying dopant-containing glass-forming gases to the interior of the hollow glass substrate tube (14), wherein the supply flow comprises a main gas flow (6) and one or more secondary gas flows (5), said main gas flow (6) mainly comprising the glass-forming gases and one or more dopants and said one or more secondary gas flows (5) mainly comprising dopant(s),
iii) creating such conditions in the interior of the hollow glass substrate tube (14) by moving a plasma zone over the longitudinal axis of the hollow glass substrate tube (14) between a point of reversal near the inlet side of the hollow glass substrate tube (14) and a point of reversal near the outlet side of the hollow glass substrate tube (14) that deposition of glass layers on the interior of the hollow glass substrte tube (14) takes place, and possibly
iv) subjecting the substrate tube (14) thus obtained to a collapsing treatment so as to form a solid preform,

**characterised in that** the secondary gas flow (5) is subdivided into N subflows (9, 10, 11, 12), which N subflows (9, 10, 11, 12) are supplied to the interior of the hollow glass substrate tube (14) together with the main gas flow (6), wherein $N \geq 2$, wherein the flow rate of one or more secondary gas flows (5) is set in dependence on the position of the plasma zone over the longitudinal axis of the hollow substrate tube, at least during part of step iii).

2. A method according to claim 1, **characterised in that** the number of subflows (9, 10, 11, 12) is at least 4, viz. $N \geq 4$, especially that the maximum flow of subflow $N_1$ is twice as large as the maximum flow of subflow $N_2$, if N = 2.

3. A method according to one or more of the preceding claims, **characterised in that** the maximum flow of subflow $N_1$ is twice as large as the maximum flow of subflow $(N_i-1)$, and the maximum flow of subflow N is twice as small as the maximum flow of subflow $(N_1+1)$, wherein $N \geq 3$.

4. A method according to one or more of the preceding claims, **characterised in that** said one or more secondary gas flows (5) take place in a temperature-controlled environment.

5. A method according to one or more of the preceding claims, **characterised in that** a controllable valve and an orifice are present in the flow path of each subflow (9, 10, 11, 12), with the controllable valve blocking or passing the respective subflow (9, 10, 11, 12) and the orifice controlling the magnitude of the respective subflow.

6. A method according to claim 5, **characterised in that** the control frequency used for controlling the controllable valve is at least 20 Hz, especially that said control frequency is at least 50 Hz.

7. A method according to one or more of claims 5-6, **characterised in that** the control of the controllable valve(s) takes place as a function of time during step iii), especially that said control takes place by comparing a previously determined refractive index profile with a desired refractive index profile, the difference between the two profiles functioning as a basis for setting the flow rate of at least one of the main gas flow(6) and the secondary gas flow (5) for carrying out steps ii)-iii).

8. A method according to one or more of the preceding claims, **characterised in that** in step iii) a plasma zone is moved at a velocity in the 10-40 m/min range between the two points of reversal.

9. A device for supplying gases to the interior of a hollow substrate tube (14), in which hollow substrate tube (14) an internal deposition process is carried out using a plasma zone movable along the length of said substrate tube (14), with the supply flow comprising a main gas flow (6) and one or more secondary gas flows (5), said main gas flow (6) mainly comprising the glass-forming gases and said one or more secondary gas flows (5) mainly comprising dopant(s), **characterised in that** the secondary gas flow (5) comprises a first distribution unit for dividing the secondary gas flow (5) into N subflows (9, 10, 11, 12) and a second distribution unit for combining all N subflows (9, 10, 11, 12), wherein $N \geq 2$, in which device a controllable vale and an orifice are present in the flow path of each subflow(9, 10, 11, 12), with the controllable valve blocking or passing the respective subflow (9, 10, 11, 12) and the orifice controlling the magnitude of the respective subflow (9, 10, 11, 12), said valve being controlled via an electronically controlled measuring and control system to realise any desired refractive index value at any desired position in the hollow substrate tube (14).

10. A device according to claim 9, **characterised in that** the first distribution unit, the second distribution unit and the associated valve(s) and orifice(s) are disposed in a temperature-controlled environment.

**Patentansprüche**

1. Verfahren zur Herstellung einer Vorform für Glasfasern mittels eines internen Gasabscheidungsprozesses, das die folgenden Schritte umfasst:

i) Bereitstellen eines hohlen Glassubstratrohres (14),

ii) Zuführen von Dotanden enthaltenden, glasbildenden Gasen in das Innere des Glassubstratrohres (14), wobei der Zuführstrom einen Hauptgasstrom (6) und einen oder mehrere sekundäre Gasströme (5) aufweist, der Hauptgasstrom (6) hauptsächlich die glasbildenden Gase und einen oder mehrere Dotanden aufweist und die einen oder mehreren sekundären Gasströme (5) hauptsächlich Dotanden aufweisen,

iii) Erzeugen solcher Bedingungen im Inneren des hohlen Glassubstratrohres (14) durch Bewegen einer Plasmazone über die Längsachse des hohlen Glassubstratrohres (14) zwischen einem Umkehrpunkt nahe der Einlassseite des hohlen Glassubstratrohres (14) und einem Umkehrpunkt nahe der Auslassseite des hohlen Glassubstratrohres (14), dass eine Abscheidung von Glasschichten im Inneren des hohlen Glassubstratrohres (14) erfolgt, und wahlweise

iv) Aussetzen des auf diese Weise erhaltenen Substratrohres (14) einer Kollabierungsbehandlung, um eine massive Vorform zu bilden,

**dadurch gekennzeichnet, dass** der sekundäre Gasstrom (5) in N Unterströme (9, 10, 11, 12) unterteilt ist, die dem Inneren des hohlen Glassubstratrohres (14) zusammen mit dem Hauptgasstrom zugeführt werden, wobei $N \geq 2$, wobei der Durchsatz eines oder mehrere sekundärer Gasströme (5) wenigstens während eines Teils des Schritts iii) in Abhängigkeit der Position der Plasmazone über die Längsachse des hohlen Glassubstratrohres bestimmt wird.

2. Verfahren nach Anspruch 1, **dadurch gekennzeichnet, dass** die Anzahl der Unterströme (9, 10, 11, 12) wenigstens 4 ist, d.h. $N \geq 4$, insbesondere dass der größte Durchsatz des Unterstroms $N_1$ doppelt so groß wie der größte Durchsatz des Unterstroms $N_2$, wenn N = 2.

3. Verfahren nach einem oder mehreren der vorhergehenden Ansprüche, **dadurch gekennzeichnet, dass** der größte Durchsatz des Unterstroms $N_1$ doppelt so groß wie der größte Durchsatz des Unterstroms $(N_1-1)$ ist, und dass der größte Durchsatz des Unterstroms $N_1$ halb so groß wie der größte Durchsatz des Unterstroms $(N_1+1)$ ist, wobei $N \geq 3$.

4. Verfahren nach einem oder mehreren der vorhergehenden Ansprüche, **dadurch gekennzeichnet, dass** einer oder mehrere der sekundären Gasströme (5) in einer temperaturgeführten Umgebung erfolgen.

5. Verfahren nach einem oder mehreren der vorhergehenden Ansprüche, **dadurch gekennzeichnet, dass** ein steuerbares Ventil und ein Durchlass im Strömungsweg jedes Unterstroms (9, 10, 11, 12) vorgesehen sind, wobei das steuerbare Ventil den zugehörigen Unterstrom (9, 10, 11, 12) blockiert oder passieren lässt und der Durchlass die Menge des jeweiligen Unterstroms steuert.

6. Verfahren nach Anspruch 5, **dadurch gekennzeichnet, dass** die Steuerfrequenz, die zur Steuerung des steuerbaren Ventils verwendet wird, wenigstens 20 Hz, insbesondere wenigstens 50 Hz ist.

7. Verfahren nach einem oder mehreren der Ansprüche 5 - 6, **dadurch gekennzeichnet, dass** die Steuerung der steuerbaren Ventile während Schritt iii) als Funktion der Zeit erfolgt, insbesondere dass die Steuerung durch Vergleichen eines zuvor bestimmten Brechungsindexprofils mit einem gewünschten Brechungsindexprofil erfolgt, wobei der Unterschied zwischen den beiden Profilen als Grundlage für die Bestimmung des Durchsatzes des Hauptgasstromes (6) und/oder des sekundären Gasstromes (5) dient, um die Schritte ii) - iii) durchzuführen.

8. Verfahren nach einem oder mehreren der vorhergehenden Ansprüche, **dadurch gekennzeichnet, dass** in Schritt iii) eine Plasmazone mit einer Geschwindigkeit im Bereich von 10 - 40 m/min zwischen zwei Umkehrpunkten bewegt wird.

9. Vorrichtung zum Zuführen von Gasen in das Innere eines hohlen Glassubstratrohres (14), in dem ein interner Gasabscheidungsprozess unter Verwendung einer Plasmazone durchgeführt wird, die entlang der Länge des hohlen Glassubstratrohres (14) bewegbar ist, wobei der Zuführstrom einen Hauptgasstrom (6) und einen oder mehrere sekundäre Gasströme (5) aufweist, der Hauptgasstrom (6) hauptsächlich die glasbildenden Gase aufweist und die einen oder mehreren sekundären Gasströme (5) hauptsächlich Dotanden aufweisen, **dadurch gekennzeichnet, dass** der sekundäre Gasstrom (5) eine erste Verteilereinheit zum Teilen des sekundären Gasstroms (5) in N Unterströme (9, 10, 11, 12) und eine zweite Verteilereinheit zum Mischen aller N Unterströme (9, 10, 11, 12) aufweist, wobei $N \geq 2$, und dass in der Vorrichtung ein steuerbares Ventil und ein Durchlass im Strömungsweg jedes Unterstroms (9, 10, 11, 12) vorgesehen sind, wobei das steuerbare Ventil den zugehörigen Unterstrom (9, 10, 11, 12) blockiert oder passieren lässt und der Durchlass die Menge des jeweiligen Unterstroms steuert, wobei das Ventil von einem elektronisch gesteuerten Mess- und Steuersystem gesteuert ist, um jeden gewünschten Wert des Brechungsindex an jeder gewünschten Position im hohlen Glassubstratrohr (14) zu realisieren.

**10.** Vorrichtung nach Anspruch 9, **dadurch gekennzeichnet, dass** die erste Verteilereinheit, die zweite Verteilereinheit und die zugehörigen Ventile und Durchlässe in einer temperaturgeführten Umgebung angeordnet sind.

## Revendications

**1.** Procédé de fabrication d'une préforme pour fibres optiques au moyen d'un processus de dépôt en phase vapeur interne, lequel procédé comprend les étapes suivantes :

> i) la fourniture d'un tube de substrat en verre creux (14),
> ii) l'apport de gaz vitrifiants contenant un dopant à l'intérieur du tube de substrat en verre creux (14), dans lequel l'écoulement d'apport comprend un écoulement de gaz principal (6) et un ou plusieurs écoulements de gaz secondaires (5), ledit écoulement de gaz principal (6) comprenant principalement les gaz vitrifiants et un ou plusieurs dopants et lesdits un ou plusieurs écoulements de gaz secondaires (5) comprenant principalement un ou des dopants,
> iii) la création de telles conditions à l'intérieur du tube de substrat en verre creux (14) en déplaçant une zone de plasma sur l'axe longitudinal du tube de substrat en verre creux (14) entre un point du renversement proche du côté d'admission du tube de substrat en verre creux (14) et un point de renversement proche du côté de refoulement du tube de substrat en verre creux (14) que le dépôt de couches de verre sur l'intérieur du tube de substrat en verre creux (14) a lieu, et éventuellement
> iv) la soumission du tube de substrat (14) ainsi obtenu à un traitement d'effondrement de façon à former une préforme pleine,

**caractérisé en ce que** l'écoulement de gaz secondaire (5) est subdivisé en N sous-écoulements (9, 10, 11, 12), lesquels N sous-écoulements (9, 10, 11, 12) sont apportés à l'intérieur du tube de substrat en verre creux (14) conjointement avec l'écoulement de gaz principal (6), dans lequel $N \geq 2$, dans lequel le débit d'un ou plusieurs écoulements de gaz secondaires (5) est établi selon la position de la zone de plasma sur l'axe longitudinal du tube de substrat creux, au moins pendant une partie de l'étape iii).

**2.** Procédé selon la revendication 1, **caractérisé en ce que** le nombre de sous-écoulements (9, 10, 11, 12) s'élève au moins à 4, c'est-à-dire $N \geq 4$, en particulier que l'écoulement maximal du sous-écoulement $N_1$ est deux fois plus grand que l'écoulement maximal du sous-écoulement $N_2$, si $N = 2$.

**3.** Procédé selon une ou plusieurs des revendications précédentes, **caractérisé en ce que** l'écoulement maximal de sous-écoulement $N_1$ est deux fois plus grand que l'écoulement maximal du sous-écoulement $(N_1-1)$, et l'écoulement maximal du sous-écoulement N est deux fois plus petit que l'écoulement maximal du sous-écoulement $(N_1 + 1)$, dans lequel $N \geq 3$.

**4.** Procédé selon une ou plusieurs des revendications précédentes, **caractérisé en ce que** lesdits un ou plusieurs écoulements de gaz secondaires (5) ont lieu dans un environnement à température régulée.

**5.** Procédé selon une ou plusieurs des revendications précédentes, **caractérisé en ce qu'**une vanne commandable et un orifice sont présents dans le chemin d'écoulement de chaque sous-écoulement (9, 10, 11, 12), la vanne commandable bloquant ou laissant passer le sous-écoulement respectif (9, 10, 11, 12) et l'orifice régulant la grandeur du sous-écoulement respectif.

**6.** Procédé selon la revendication 5, **caractérisé en ce que** la fréquence de commande utilisée pour commander la vanne commandable est d'au moins 20 Hz, en particulier **en ce que** ladite fréquence de commande est d'au moins 50 Hz.

**7.** Procédé selon une ou plusieurs des revendications 5 à 6, **caractérisé en ce que** la commande de la ou des vannes commandables a lieu en fonction du temps pendant l'étape iii), en particulier **en ce que** ladite commande a lieu en comparant un profil d'indice de réfraction précédemment déterminé à un profil d'indice de réfraction souhaité, la différence entre les deux profils fonctionnant comme base d'établissement du débit d'au moins l'un de l'écoulement de gaz principal (6) et de l'écoulement de gaz secondaire (5) pour réaliser les étapes ii) à iii).

**8.** Procédé selon une ou plusieurs des revendications précédentes, **caractérisé en ce qu'**à l'étape iii) une zone de plasma est déplacée à une vitesse dans la plage de 10 à 40 m/min entre les deux points de renversement.

**9.** Dispositif d'apport de gaz à l'intérieur d'un tube de substrat creux (14), dans lequel tube de substrat creux (14) un processus de dépôt interne est réalisé en utilisant une zone de plasma déplaçable suivant la longueur dudit tube de substrat (14), l'écoulement d'apport comprenant un écoulement de gaz principal (6) et un ou plusieurs écoulements de gaz secondaires (5), ledit écoulement de gaz principal (6) comprenant principalement les gaz vitrifiants et lesdits un ou plusieurs écoulements de gaz secondaires (5) comprenant principalement un ou des dopants, **ca-**

**ractérisé en ce que** l'écoulement de gaz secondaire (5) comprend une première unité de distribution permettant de diviser l'écoulement de gaz secondaire (5) en N sous-écoulements (9, 10, 11, 12), et une seconde unité de distribution permettant de combiner la totalité des N sous-écoulements (9, 10, 11, 12), dans lequel N $\geq$ 2, dans lequel dispositif une vanne commandable et un orifice sont présents dans le chemin d'écoulement de chaque sous-écoulement (9, 10, 11, 12), la vanne commandable bloquant ou laissant passer les sous-écoulements respectifs (9, 10, 11, 12) et l'orifice commandant la grandeur du sous-écoulement respectif (9, 10, 11, 12), ladite vanne étant commandée via un système de mesure et de commande à commande électronique afin d'atteindre toute valeur d'indice de réfraction souhaitée à toute position souhaitée dans le tube de substrat creux (14).

10. Dispositif selon la revendication 9, **caractérisé en ce que** la première unité de distribution, la seconde unité de distribution et la ou les vannes et le ou les orifices associés sont disposés dans un environnement à température régulée.

Figure

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4445918 A
- US 4816050 A
- US 20030084685 A
- JP 59121129 A
- US 4741747 A
- US 4857091 A
- EP 0038982 A
- EP 0333580 A
- GB 2118165 A
- US 5188648 A
- US 20050041943 A